# EUROPEAN PATENT APPLICATION

(11) **EP 4 447 104 A1**
(43) Date of publication of application: **16.10.2024**
(21) Application number: 22902902.0
(22) Date of filing: 29.08.2022
(51) Int. Cl.: H01L 23/367, H01L 23/373

(54) **LIQUID METAL PACKAGING STRUCTURE FOR HEAT DISSIPATION OF CHIP**

(30) Priority: 10.12.2021 CN 202123119430 U
(71) Applicant: Yunnan Zhongxuan Liquid Metal Technology Co., Ltd, Qujing, Yunnan 655499 (CN)
(72) Inventor: CAI, Changli, Yunnan 655499 (CN); GENG, Chengdu, Yunnan 655499 (CN); WANG, Jian, Yunnan 655499 (CN); AN, Jianping, Yunnan 655499 (CN); DU, Wangli, Yunnan 655499 (CN); YANG, Yingbao, Yunnan 655499 (CN); ZHANG, Ji, Yunnan 655499 (CN); TANG, Huifang, Yunnan 655499 (CN); WU, Shixuan, Yunnan 655499 (CN); YANG, Zhenmin, Yunnan 655499 (CN)
(74) Representative: Zaboliene, Reda
(86) International application number: PCT/CN2022/115558
(87) International publication number: WO 2023/103470

(57) **Abstract**

The disclosure discloses a liquid metal packaging structure for chip heat dissipation, comprising: a fixing frame and a sealing frame, wherein a chip is provided in the inner frame of the sealing frame, and a heat sink is provided on side of the sealing frame away from the electronic component, and the heat sink is hermetically covered on an end surface of the sealing frame, the sealing frame is filled with liquid metal, and the heat sink is integrally molded with a pressing block at a position corresponding to the inner frame of the sealing frame, and the liquid metal is arranged between the chip and the pressing block. According to the liquid metal packaging structure for chip heat dissipation, the sealing frame is fixed by the fixing frame, and the sealing frame is filled with liquid metal.

## Description

### CROSS-REFERENCE TO TELATED APPLICATION

This application claims priority to Chinese Patent Application No. 202123119430.X, titled "Liquid Metal Packaging Structure For Chip Heat Dissipation", filed on Dec. 10, 2021, and the present disclosure name is "Liquid Metal Packaging Structure For Chip Heat Dissipation", which are incorporated herein by reference in their entirety.

### TECHNICAL FIELD

The disclosure relates to the technical field of heat dissipation elements, in particular to a liquid metal packaging structure for chip heat dissipation.

### BACKGROUND

Liquid metal, as a thermal interface material, is gradually accepted by major electronic manufacturers. However, at present, the liquid metal packaging structure for heat dissipation mostly adopts composite packaging method with foam frame and sealant, which has a more complex process structure and involves the steps of making sponge frames, dispensing sealant, and forming composite dams. The manufacture is difficult and prone to aging and leakage during use.

### SUMMARY

The present disclosure provides a liquid metal packaging structure for chip heat dissipation, which solves the technical problems that the existing liquid metal packaging heat dissipation structure is difficult to manufacture and prone to aging and leaking.

The present disclosure provides a liquid metal packaging structure for chip heat dissipation, comprising:

a fixing frame and a sealing frame, wherein a chip is provided in the inner frame of the sealing frame, a heat sink is provided on side of the sealing frame away from the electronic component, the heat sink is integrally molded with a pressing block, collectively referred to as a radiator; the sealing frame is filled with liquid metal, which completely cover the chip and is in full contact with the end surface of the pressing block. According to the liquid metal packaging structure for chip heat dissipation, the sealing frame is fixed by the fixing frame, and the sealing frame is filled with liquid metal; the liquid surface of the liquid metal is prevented from being flush with the sealing frame through the contact of the pressing block with the liquid surface of the liquid metal, so that the end surface of the radiator and the joint of the sealing frame can better seal the liquid metal and prevent the liquid metal from leaking between the end surface of the radiator and the sealing frame.

In some examples, a first insulating film is sealed between the heat sink and the sealing frame.

In some examples, the sealing frame is made of a flexible material with a temperature resistance of 150°C or more.

In some examples, the sealing frame is provided with a cavity corresponding to the end surface of the electronic component, and the electronic component is provided in the cavity.

In some examples, an insulating layer is arranged between the sealing frame and the electronic component.

In some examples, the insulating layer comprises a protective layer and a second insulating film provided in sequence, and the protective layer is in contact with the electronic component.

In some examples, the inner frame of the sealing frame is greater than or equal to the chip undercut angle in size.

In some examples, the outer frame of the sealing frame is equal to the fixing frame in size.

In some examples, the pressing block is a square convex platform, and a cavity is arranged between the side surface of the chip and the inner wall of the sealing frame.

The beneficial effects of the present disclosure are as follows:

According to the liquid metal packaging structure for chip heat dissipation, the sealing frame is fixed by the fixing frame, and the sealing frame is filled with liquid metal; the liquid surface of the liquid metal is prevented from being flush with the sealing frame through the contact of the pressing block with the liquid surface of the liquid metal, so that the end surface of the heat sink and the joint of the sealing frame can better seal the liquid metal and prevent the liquid metal from leaking between the end surface of the heat sink and the sealing frame.

### BRIEF DESCRIPTION OF THE DRAWINGS

In order to more clearly explain the example of the disclosure or the existing technical scheme, the drawings needed in the description of the example will be briefly introduced below. Obviously, the drawings in the following description are only some examples of the disclosure.

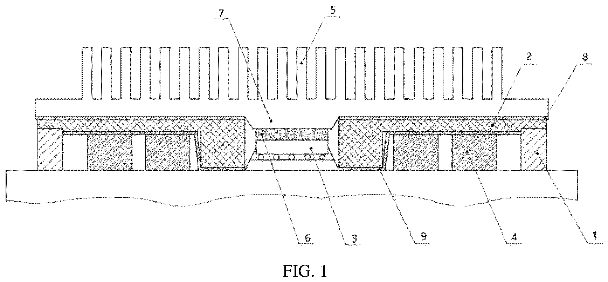

FIG. 1 shows a schematic diagram of the overall structure of the package structure provided by the present disclosure.

### DETAILED DESCRIPTION OF THE EMBODIMENTS

By providing a liquid metal packaging structure for chip heat dissipation, the example of the present disclosure solves technical problems that the existing liquid metal packaging heat dissipation structure is prone to aging and leaking.

In order to solve the above technical problems, the general idea in the example of this present disclosure is as follows:
As shown in FIG. 1, the present disclosure provides a liquid metal packaging structure for chip heat dissipation, comprising: a fixing frame 1 and a sealing frame 2, wherein the fixing frame 1 is located outside a chip 3 and an electronic component 4, the sealing frame 2 is provided inside the fixing frame 1, the sealing frame 2 seals the electronic component 4, the chip 3 is provided in the inner frame of the sealing frame 2, and a heat sink 5 is provided on side of the sealing frame 2 away from the electronic component 4, the heat sink 5 is hermetically covered on an end surface of the sealing frame 2, the sealing frame 2 is filled with liquid metal 6, and the liquid metal 6 completely covers the chip 3; the heat sink 5 is integrally molded with a pressing block 7 at a position corresponding to the inner frame of the sealing frame 2, and the pressing block 7 is in contact with the liquid surface of the liquid metal 6; the heat sink 5 is integrally molded with a pressing block 7, collectively referred to as a radiator; the liquid metal 6 is arranged between the pressing block 7 and the chip 3, due to surface tension of the liquid metal 6, the liquid metal 6 can maintain a certain shape between the block 7 and the chip 3.

The sealing frame 2 is fixed by the fixing frame 1, and the sealing frame 2 is filled with liquid metal 6; the liquid surface of the liquid metal 6 is prevented from being flush with the sealing frame 2 through the contact of the pressing block 7 with the liquid surface of the liquid metal 6, so that the joint of the heat sink 5 and the sealing frame 2 can better seal the liquid metal 6; the position of the heat sink 5 corresponding to the chip 3 is not easy to deform due to its higher strength, thus preventing the liquid metal 6 from leaking between the heat sink 5 and the sealing frame 2.

The inner frame of the sealing frame 2 is greater than or equal to the chip 3 undercut angle in size, and the outer frame of the sealing frame 2 is equal to the fixing frame 1 in size, so that the sealing frame 2 is more easily to be installed and fixed. After the sealing frame 2 is installed, the size of the inner frame of the sealing frame 2 is larger than the chip 3 undercut angle by 3-10 µm, preferably 5 µm; after the heat sink 5 is installed, the gap between the chip 3 and the radiator surface is 0.08-0.2 mm, preferably 0.1-0.12 mm.

In order to better understand the above technical scheme, it will be described in detail combined with the attached drawings and specific examples.

The sealing frame 2 is made of a flexible material with temperature resistance of 150°C or more, specifically, the sealing frame 2 is made of silica gel or rubber, and the sealing frame 2 can be preformed in advance, or formed by dispensing and curing.

The preforming process of the sealing frame 2 comprises following steps: sampling data on the dimensions of the space around the chip 3, and forming the sealing frame 2 with required shape and size by die cutting, stamping or casting, so that the sealing frame 2 can be embedded with the chip 3 and surrounding electronic component 4, and the contact surface of sealing frame 2 and radiator can be a plane;
Process of the sealing frame 2 formed by dispensing and curing comprises following steps: applying a dispensing machine to dispense sealant around the chip 3 to form a sealing frame 2 so that the bottom of the sealing frame 2 can enclose the electronic component 4 around the chip 3, and the surface of the sealing frame 2 can form a flat surface; the sealant is viscous before curing, not easy to flow, and can better maintain the shape; the sealant can also be hot melt adhesive, which can be cured quickly and maintain the shape.

The sealing frame 2 is provided with a cavity corresponding to the end surface of the electronic component 4, and the electronic component 4 is provided in the cavity.

Further, a first insulating film 8 is sealed between the heat sink 5 and the sealing frame 2, and an insulating layer 9 is arranged between the sealing frame 2 and the electronic component 4, the insulating layer 9 comprises a protective layer and a second insulating film provided in sequence, the first insulating film 8 and the second insulating film are made of PI (polyimide) film, and the protective layer is made of three-proof paint, with these settings, the sealing protection between the electronic component 4, the sealing frame 2 and the heat sink 5 is better, and leakage of the liquid metal 6 can be avoided.

The insulating layer 9 protects the electronic component 4 and prevents the sealing frame 2 from damaging the electronic component 4 during the manufacturing process.

Further, the pressing block 7 is a square convex platform, and a cavity is arranged between the side surface of the chip 3 and the inner wall of the sealing frame 2, the pressing block 7 is convenient to be installed in the inner frame of the sealing frame 2; at the same time, the liquid surface of the liquid metal 6 is controlled to be lower than the end surface of the sealing frame 2, and if too much liquid metal is added to the sealing frame, the cavity is able to cushion the liquid metal and prevent the liquid metal 6 from leaking between the heat sink 5 and the sealing frame 2.

Although the preferred examples of the disclosure have been described, those skilled in the art can make additional changes and modifications to these examples once they know the basic creative concepts. Therefore, the appended claims are intended to be interpreted as including the preferred example and all changes and modifications that fall within the scope of the disclosure.

Obviously, those skilled in the art can make various changes and variants to the disclosure without departing from the spirit and scope of the disclosure. Thus, if these modifications and variations of the disclosure are within the scope of the disclosure claims and their equivalent technologies, the disclosure also intends to include these modifications and variations.

## Claims

1. A liquid metal packaging structure for chip heat dissipation, comprising: a fixing frame and a sealing frame, wherein the fixing frame is located outside a chip and an electronic component, the sealing frame is provided inside the fixing frame, the sealing frame seals the electronic component, and the chip is provided in inner frame of the sealing frame, wherein
a heat sink is provided on side of the sealing frame away from the electronic component, the heat sink is hermetically covered on an end surface of the sealing frame, the sealing frame is filled with liquid metal, and the heat sink is integrally molded with a pressing block at a position corresponding to the inner frame of the sealing frame, and the liquid metal is arranged between the chip and the pressing block.

2. The liquid metal packaging structure for chip heat dissipation as claimed in claim 1, wherein a first insulating film is sealed between the heat sink and the sealing frame.

3. The liquid metal packaging structure for chip heat dissipation as claimed in claim 1, wherein the sealing frame is made of a flexible material with a temperature resistance of 150°C or more.

4. The liquid metal packaging structure for chip heat dissipation according to claim 1, wherein the sealing frame is provided with a cavity corresponding to the end surface of the electronic component, and the electronic component is provided in the cavity.

5. The liquid metal packaging structure for chip heat dissipation as claimed in claim 4, wherein an insulating layer is arranged between the sealing frame and the electronic component.

6. The liquid metal packaging structure for chip heat dissipation as claimed in claim 5, wherein the insulating layer comprises a protective layer and a second insulating film provided in sequence, and the protective layer is in contact with the electronic component.

7. The liquid metal packaging structure for chip heat dissipation according to claim 1, wherein the inner frame of the sealing frame is greater than or equal to the chip undercut angle in size.

8. The liquid metal packaging structure for chip heat dissipation as claimed in claim 1, wherein the outer frame of the sealing frame is equal to the fixing frame in size.

9. The liquid metal packaging structure for chip heat dissipation according to claim 1, wherein the pressing block is a square convex platform, and a cavity is arranged between the side surface of the chip and the inner wall of the sealing frame.
